# EUROPÄISCHE PATENTANMELDUNG

(11) **EP 0 991 112 A2**
(43) Veröffentlichungstag der Anmeldung: **05.04.2000**
(21) Anmeldenummer: 99118006.8
(22) Anmeldetag: 20.09.1999
(51) Int. Cl.: H01L 21/00

(54) **Fahrbarer Transportwagen**

(30) Priorität: 02.10.1998 DE 19845350
(71) Anmelder: Ortner Reinraumtechnik GmbH, 9500 Villach (AT)
(72) Erfinder: Ortner, Josef, 9872 Millstatt (AT)
(74) Vertreter: Becker, Thomas, Dr., Dipl.-Ing.

(57) **Zusammenfassung**

Die Erfindung betrifft einen verfahrbaren Transportwagen, der an einer Maschine in einer definierten Position festlegbar ist.

## Beschreibung

Die Erfindung betrifft einen fahrbaren Transportwagen, der an einer Maschine in einer definierten Position festlegbar ist.

In zahlreichen Bereichen der Technik ist es notwendig, bestimmte Teile von einer Stelle zu einer anderen zu transportieren, insbesondere zu einer Maschine zu bringen, mit der die Teile behandelt und/oder weiter verarbeitet werden.

Im Rahmen zunehmender Automatisierung wird dabei angestrebt, die auf dem Transportwagen befindlichen Teile mechanisch abnehmen und auf oder in die Maschine einsetzen zu können beziehungsweise umgekehrt die Teile von der Maschine wieder auf den Transportwagen zurückzusetzen.

Sowohl der Stand der Technik als auch die Erfindung werden nachstehend anhand eines fahrbaren Transportwagens für sogenannte Wafer-Kassetten näher beschrieben. Die regalartig aufgebauten Kassetten dienen zur Aufnahme von Wafern (Halbleiter-Scheiben). Die Wafer werden in einer Vielzahl von Teilschritten behandelt und/oder bearbeitet, bis der gewünschte Chip fertig ist. Dabei kann der Wafer bis zu 250 Bearbeitungsschritte durchlaufen. Entsprechend oft müssen die zugehörigen Kassetten, in denen die Wafer gelagert oder transportiert werden, zu den entsprechenden Maschinen geführt beziehungsweise von dort weitertransportiert werden.

Der Transport und die Bearbeitung der Wafer (Waferkassetten) erfolgt aufgrund der Empfindlichkeit der Halbleiter in Reinräumen mit einem hohen Automatisierungsgrad.

Bisher werden die Kassetten auf einem mit Rollen ausgerüsteten Transportwagen an die jeweilige Maschine geschoben und danach auf oder in die Maschine umgesetzt. Dies erfolgt teilweise mit automatisierten Greifern nach Art von Robotern.

Ein besonderes Problem stellt dabei die exakte Positionierung des Transportwagens an oder neben der Maschine dar. Nur dann, wenn der Transportwagen stets in derselben, definierten Position zur Maschine steht können die Kassetten in definierter Position ergriffen und in definierter Position auf oder in der Maschine abgesetzt werden.

Der Erfindung liegt insoweit die Aufgabe zugrunde, einen Transportwagen anzubieten, der eine exakte Positionierung an einer zugehörigen Maschine ermöglicht. Er soll darüber hinaus vorzugsweise so gestaltet sein, daß die auf dem Transportwagen befindlichen Teile, insbesondere Waferkassetten leicht und sicher zur Maschine und zurück geführt werden können.

Der Erfindung liegen folgende Ansätze zugrunde:

Transportwagen der genannten Art sind üblicherweise mit vier bodenseitigen Rollen ausgebildet, wie dies analog von Krankenhausbetten oder Servierwagen bekannt ist. Diese Rollen ermöglichen jedoch keine präzise, millimetergenaue Führung der Transportwagen.

Insoweit ist es notwendig, den Transportwagen mit zusätzlichen Führungs- und Justiermitteln auszubilden.

Hierzu dient erfindungsgemäß eine am Transportwagen angeordnete Einrichtung, die im wesentlichen zwei Komponenten umfaßt:
- mindestens einen Gleitkörper, der auf beziehungsweise in eine korrespondierende, maschinenseitige Schiene setzbar ist,
- mindestens ein Rastmittel, welches mit einem korrespondierenden, maschinenseitig angeordneten Rastteil verrastbar ist.

Dem Gleitkörper kommt dabei die Aufgabe zugrunde, nach einer Grobpositionierung des Transportwagens an der Maschine (über die Rollen des Transportwagens) eine definierte weitere Führung des Transportwagens zu erlauben, und zwar entlang der maschinenseitig angeordneten Schiene.

Die Relativverschiebung des Transportwagens zur Maschine erfolgt dann in Richtung des maschinenseitigen Rastteils, bis das am Transportwagen angeordnete Rastmittel mit diesem Rastteil verrastet ist.

Die so erreichte Position des Transportwagens entspricht der gewünschten, definierten Position des Transportwagens gegenüber der zugehörigen Maschine.

Danach betrifft die Erfindung in ihrer allgemeinsten Ausführungsform einen fahrbaren Transportwagen, der an einer Maschine in einer definierten Position festlegbar ist, und folgende Merkmale aufweist:
- eine, am Transportwagen angeordnete und über eine Seitenwand des Transportwagens vorstehende Einrichtung,
- die Einrichtung weist mindestens einen, in einer maschinenseitig horizontal verlaufenden Schiene führbaren Gleitkörper auf,
- die Einrichtung weist ferner mindestens ein Rastmittel auf, welches mit einem korrespondierenden, maschinenseitig angeordneten Rastteil verrastbar ist.

Üblicherweise wird der Transportwagen im wesentlichen eine Quaderform aufweisen mit vier, senkrecht zueinander verlaufenden Seitenwänden. Dabei steht eine Seitenwand gegenüber der Maschine, die üblicherweise eine zur Seitenwand parallele Frontfläche besitzt.

Die Maschine kann bodenseitig eine Auskehlung (einen Rücksprung) aufweisen, entlang der die genannte Schiene auf dem Boden montiert werden kann. Die Schiene steht dann nicht in den Raum über die Frontfläche der Maschine vor.

Entsprechend steht die genannte Einrichtung des Transportwagens über die korrespondierende Seitenwand des Transportwagens bodenseitig vor, um im Ergebnis den Transportwagen so dicht wie möglich gegenüber der Maschine zu positionieren.

Daraus folgt weiter, daß der Transportwagen zunächst senkrecht zur Frontfläche der Maschine an die Maschine geführt werden muß.

Entsprechend müssen die Gleitkörper des Transportwagens so ausgebildet sein, daß sie möglichst reibungsarm auf oder in die Schiene geführt werden können.

Dazu sieht eine Ausführungsform vor, die Gleitkörper an ihrem, dem Transportwagen zugewandten Ende um eine horizontal verlaufende Achse drehbar zu führen und an ihrem anderen, der Schiene zugewandten freien Ende mit einem Führungsmittel auszubilden, welches zur reibungsarmen Bewegung entlang der Schiene geeignet ist.

Die Gleitkörper sind entsprechend nach Art von "Schwenkhebeln" bei dieser Ausführungsform gestaltet. Die endseitigen Führungsmittel können beispielsweise aus einer Rolle oder Kugel bestehen.

Wird der Transportwagen senkrecht zur Frontfläche der Maschine in Richtung auf die Maschine geführt so laufen die Kugeln der Gleitelemente beispielsweise auf eine erste Schrägfläche der Schiene auf, um anschließend in eine axiale Nut der Schiene geführt zu werden.

Sofern der Transportwagen nur mit einem Gleitkörper ausgebildet ist muß dieser eine entsprechende Länge (in Axialrichtung der Schiene) aufweisen, um eine sichere Führung zu ermöglichen.

Insoweit schlägt eine Ausführungsform der Erfindung vor, die Einrichtung mit zwei, beabstandet zueinander angeordneten Gleitkörpern auszubilden. Auf diese Weise wird eine sichere Führung entlang der Schiene gewährleistet.

Sobald die Gleitkörper beispielsweise mit ihren endseitigen Rollen in die Führungsnut der Schiene eingefedert sind hat der Transportwagen bereits seine endgültige Position senkrecht zur Stirnfläche der Maschine erreicht.

Diese Position entspricht in der Regel jedoch noch nicht der exakten Position gegenüber der Maschine.

Im weiteren wird der Transportwagen deshalb entlang der Schiene (und parallel zur Maschine) verschoben, bis die Rastmittel am Transportwagen in die maschinenseitigen Rastmittel eingerastet sind.

Dabei bietet es sich an, die maschinenseitigen Rastteile im Bereich der Schiene auszubilden, woraus folgt, daß in diesem Fall die Rastmittel des Transportwagens in der Höhe der Gleitkörper angeordnet sind.

Diese Anordnung läßt sich konkret dadurch realisieren, daß der oder die Gleitkörper und das oder die Rastmittel auf einem gemeinsamen Träger am Transportwagen angeordnet werden, wie dies in der nachfolgenden Figurenbeschreibung dargestellt ist.

Die Rastmittel und Rastteile können auf unterschiedliche Art und Weise gestaltet sein. Beispielsweise besteht das Rastmittel aus einem in Gleitrichtung des Gleitkörpers (also in Axialrichtung der Schiene) ausgerichteten, federnd geführten Rasthaken, der mit einem entsprechenden Absatz (Rücksprung) des zugehörigen Rastteils verrastet werden kann.

Über einen entsprechenden Hebelmechanismus läßt sich diese Verrastung leicht aufheben, wenn der Transportwagen wieder von der Maschine gelöst werden soll.

Die Begriffe Rastmittel und Rastteile sind nicht auf mechanische Rastorgane beschränkt. Sie umfassen beispielsweise auch magnetische Einrichtungen, mit denen der Transportwagen an der Maschine ortsfest positionierbar ist. Bei Verwendung von Elektromagneten lassen sich die Rastmittel von den Rastteilen durch Stromunterbrechung leicht wieder lösen.

Nach einer weiteren Ausführungsform sind die Rastmittel als Teil eines elektrischen Steckverbinders gestaltet, dessen korrespondierender Teil von dem maschinenseitig angeordneten Rastteil gebildet wird.

Ein Abschnitt der Rastverbindung weist dann entsprechende Kontaktstifte (Steckerteil) auf, während der andere Abschnitt mit korrespondierenden Öffnungen als Buchsenteil ausgebildet ist.

Diese Ausführungsform ermöglicht es, den maschinenseitig vorhandenen Strom auf dem Transportwagen zur Verfügung zu stellen, um dort beispielsweise einen Manipulator zu betätigen, der die zu transportierenden Teile vom Transportwagen auf die Maschine setzt oder umgekehrt.

Der Transportwagen kann dazu mit mehreren Regalflächen zur Aufnahme entsprechender, zu transportierender Teile ausgebildet sein. Nach einer Ausführungsform soll der Manipulator höhenverstellbar auf dem Transportwagen geführt werden und mindestens einen, in mindestens zwei unterschiedlichen Richtungen verfahrbaren Arm aufweisen. Auf diese Weise kann der Arm beispielsweise senkrecht und parallel zur frontseitigen Maschinenfläche sowie vertikal verfahren werden.

Der Arm kann an seinem freien Ende mit einer Greifeinrichtung ausgebildet sein, um die Teile aufzunehmen beziehungsweise abzusetzen.

Wird der Manipulator mittig zwischen entsprechende Regaleinheiten gesetzt lassen sich eine Vielzahl von Regalflächen und entsprechend eine Vielzahl von Teilen auf dem Transportwagen gemeinsam transportieren und nacheinander umsetzen.

Um die Positionierung (das Andocken) des Transportwagens an der Maschine zu erleichtern sieht eine weitere Ausführungsform der Erfindung vor, den Transportwagen mit mindestens vier bodenseitigen Rollen und mindestens vier bodenseitigen Kugeln auszubilden, wobei die Rollen und/oder die Kugeln derart verstellbar sind, daß der Transportwagen entweder auf den Rollen oder auf den Kugeln bewegbar ist.

Auf diese Weise läßt sich der Transportwagen beispielsweise über längere Strecken mittels der Rollen führen. Die Rollen werden dann, wenn der Transportwagen vor der Maschine steht, entweder vertikal nach oben verschoben (so das nun die Kugeln auf dem Boden aufliegen) oder umgekehrt werden die Kugel vertikal nach unten verschoben, so daß sie und nicht mehr die Rollen auf dem Boden aufliegen. Die Führung des Transportwagens über die Rollen erleichtert insbesondere das Andocken an die Maschine in einer Richtung senkrecht zur Stirnfläche der Maschine.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert. Dabei zeigen - jeweils in schematisierter Darstellung -
- Figur 1:: eine Seitenansicht eines Transportwagens, der an eine zugehörige Maschine angedockt ist.
- Figur 2:: eine vergrößerte, perspektivische Darstellung der Führungs- und Verbindungsmittel zwischen Transportwagen und Maschine.
- Figur 3:: eine vergrößerte, perspektivische Darstellung der Einheit A gemäß Figur 2.
- Figur 4:: einen perspektivischen Aufriß des Transportwagens nach Figur 1.

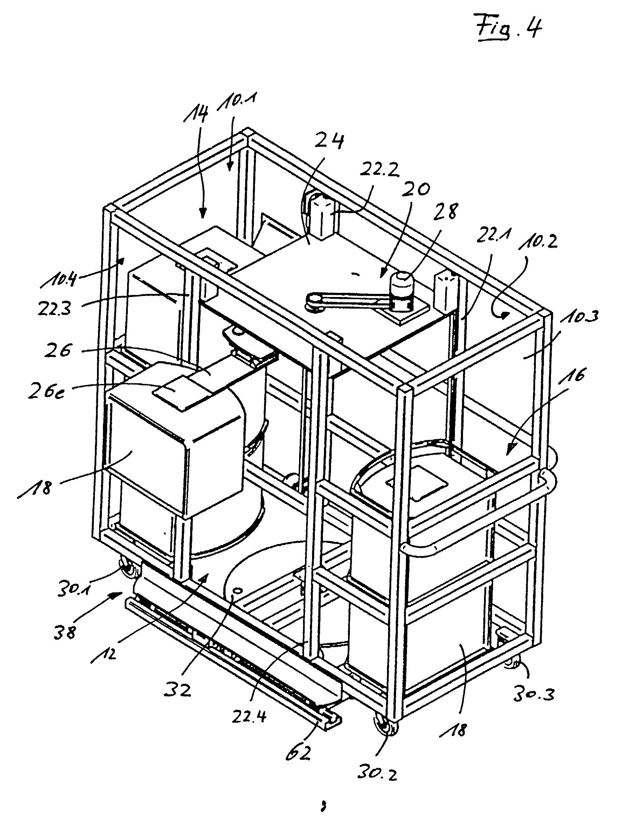

In den Figuren bezeichnet das Bezugszeichen 10 einen Transportwagen insgesamt. Dieser besteht aus einer Rahmenkonstruktion mit einem Boden 12, zwei seitlichen Regaleinheiten 14, 16 zur Aufnahme von in Figur 4 dargestellten Wafer-Kassetten 18 und einem zwischen den Regaleinheiten 14, 16 angeordneten Manipulator 20.

Der Manipulator 20 umfaßt vier, Eckpunkte eines Rechtecks durchlaufende Stützen 22.1 bis 22.4. Entlang dieser vertikalen Stützen 22.1 bis 22.4 ist eine Platte vertikal verfahrbar, an der unterseitig ein Arm 26 angeordnet ist, der sich senkrecht zu Wandflächen 10.1 bis 10.4 des Transportwagens 10 über einen motorischen Antrieb 28 bewegen läßt und an seinem freien Ende 26e eine Einrichtung (nicht dargestellt) aufweist, mit der die Waferkassetten 18 zum Transport ergriffen werden können.

Vom Boden 12 des Transportwagens 10 erstrecken sich vier Rollen nach unten, wobei drei dieser Rollen in Figur 4 zu erkennen sind und die Bezugszeichen 30.1, 30.2 und 30.3 tragen. Die Rollen 30.1 bis 30.3 sind in den Ecken des Bodens 12 angeordnet.

Am Boden 12 ist unterseitig ferner eine runde Platte 32 angeordnet, auf der in den Eckpunkten eines (gedachten) Rechtecks Hülsen 34 senkrecht nach unten abstehen, in denen nach unten vorstehende Kugeln 36 gelagert sind.

Die Platte 32 ist über (nicht dargestellte) Mittel höhenverstellbar am Boden 12 befestigt.

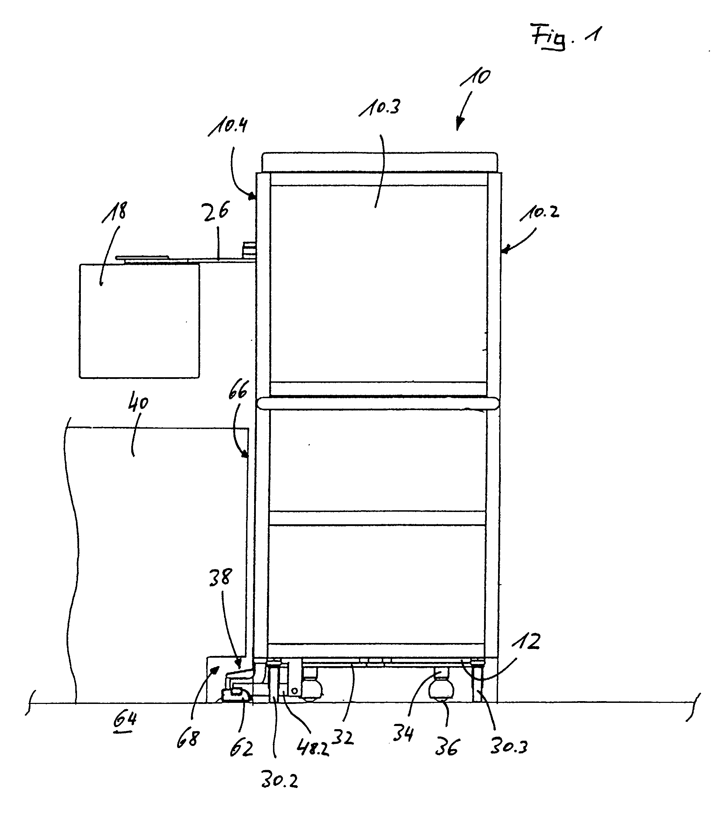

Am unteren Ende der Wandfläche 10.4 ist eine Führungs- und Justiereinrichtung 38 angeordnet, deren Einzelheiten sich aus den Figuren 1 bis 3 ergeben.

Die Einrichtung 38, die über die Wandfläche 10.4 (in Richtung auf die in Figur 1 dargestellte Maschine 40) vorsteht umfaßt zwei, beabstandet zueinander angeordnete Gleitkörper 42.1, 42.2.

Die Gleitkörper 42.1, 42.2 bestehen jeweils aus einem L-förmigen Abschnitt 44.1, 44.2, der am Boden 12 des Transportwagens 10 befestigt ist.

Am unteren Ende der Abschnitte 44.1, 44.2 ist jeweils eine horizontal verlaufende Welle 46.1, 46.2 angeordnet, auf der ein Schwenkarm 48.1 beziehungsweise 48.2 geführt wird.

Das freie Ende der Schwenkarme 48.1, 48.2 weist unterseitig eine Auskehlung 50.1, 50.2 auf, an deren stirnseitigem Ende jeweils eine in einer Hülse geführte Kugel 52.1, 52.2 frei nach unten vorsteht.

Zwischen dem lagerseitigen Ende der Schwenkarme 48.1, 48.2 und dem korrespondierenden horizontalen Schenkel der Abschnitte 44.1, 44.2 ist jeweils eine Druckfeder 54.1, 54.2 angeordnet.

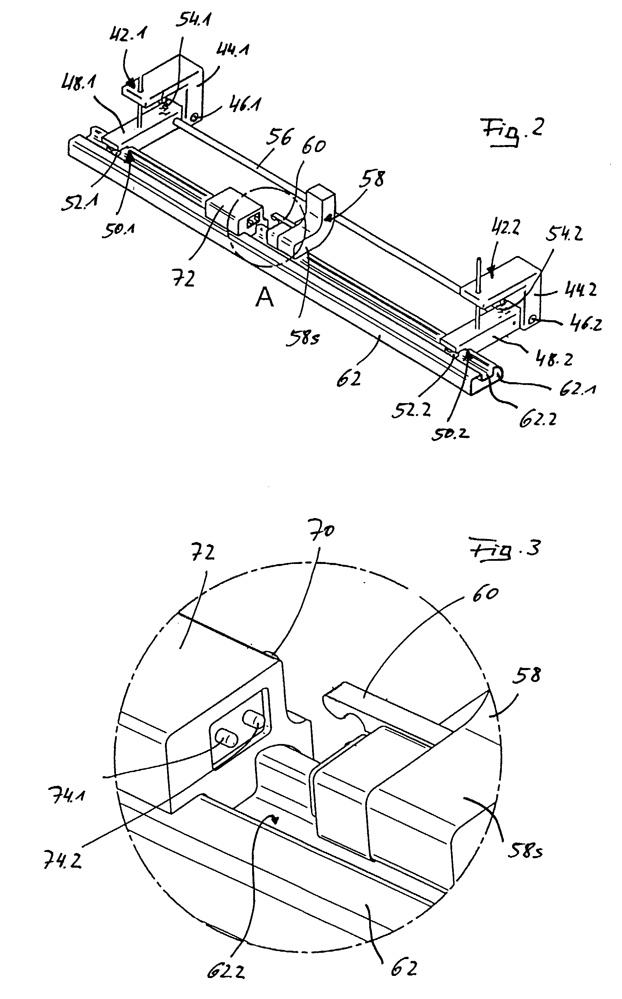

Wie Figur 2 zeigt verläuft zwischen den lagerseitigen Enden der Schwenkarme 48.1, 48.2 eine Verbindungsstange 56, auf der etwa mittig ein L-förmiger Arm 58 angeordnet ist, der mit seinem horizontalen Schenkel 58s etwa parallel zu den Schwenkarmen 48.1, 48.2 ausgerichtet ist.

Von diesem Schenkel 58s erstreckt sich senkrecht (und parallel zur Verbindungsstange 56) ein federnder Rastarm 60.

Die Figuren 1 bis 3 zeigen eine Anordnung der Einrichtung 38 im Eingriff mit einer korrespondierenden Schiene 62, die auf einem Fußboden 64 befestigt ist und parallel zur vorderen Stirnfläche 66 der Maschine 40 verläuft.

Die Schiene 62 ist in einer bodenseitigen Nut 68 der Maschine 40 angeordnet.

Nachdem der Transportwagen 10 mit Hilfe der Rollen 30.1 bis 30.3 zur Maschine 40 gefahren wurde wird die Platte 32 vertikal nach unten verfahren, bis die Kugeln 36 über die Rollfläche der Rollen 30.1 bis 30.3 vorstehen.

Der Transportwagen 10 wird dann senkrecht zur Stirnfläche 66 der Maschine 40 gegen die Maschine 40 verschoben. Dabei laufen die Kugeln 52.1, 52.2 der Schwenkarme 48.1, 48.2 auf einen ersten Abschnitt 62.1 der Schiene 62 auf, verschwenken sich gleichzeitig um die Wellen 46.1, 46.2 und federn anschließend über die Kraft der Druckfedern 54.1, 54.2 in eine Axialnut 62.2 der Schiene 62 ein. Zu diesem Zeitpunkt hat der Transportwagen 10 seine endgültige Position senkrecht zur Maschine 40 erreicht. Der Arm 58 mit dem Rastarm 60 wird um die Verbindungsstange 56 in die in Figur 3 dargestellte Position verschwenkt.

Anschließend wird der Transportwagen in Axialrichtung der Schiene 62 mit Hilfe der Kugeln 52.1, 52.2 und damit parallel zur Stirnfläche 66 der Maschine 40 verschoben, bis der Rastarm 60 hinter einen korrespondierenden Steg 70 eines auf der Schiene 62 fest angeordneten Rastteils 72 einrastet. Nun hat der Transportwagen auch in einer Ebene parallel zur Stirnfläche 66 der Maschine 40 seine endgültige Position erreicht.

Parallel zur Verrastung der Rastarms 60 mit dem Steg 70 sind Stiftkontakte 74.1, 74.2 in korrespondierende Kontaktöffnungen (nicht dargestellt) im Bereich des Arms 58 eingeführt worden, die eine elektrische Verbindung zwischen dem an eine elektrische Stromversorgung angeschlossenen Bauteil 72 und dem Transportwagen 10 schaffen. Diese elektrische Verbindung dient dazu, den Manipulator 20 mit Strom zu versorgen.

Nach dem Andocken des Transportwagens 10 an die Maschine 40 wird beispielsweise eine Kassette 18 mit der Greifeinrichtung des Greifarms 26 ergriffen und an die gewünschte Position auf oder in der Maschine 40 gesetzt.

## Patentansprüche

1. Verfahrbarer Transportwagen (10), der an einer Maschine (40) in einer definierten Position festlegbar ist, mit folgenden Merkmalen:
a) einer, am Transportwagen (10) angeordneten und über eine Seitenwand (10.4) des Transportwagens (10) vorstehenden Einrichtung (38), die
b) mindestens einen, in einer maschinenseitig horizontal verlaufenden Schiene (62) führbaren Gleitkörper (42.1, 42.2.) und
c) mindestens ein Rastmittel (60) aufweist, welches mit einem korrespondierenden, maschinenseitig angeordneten Rastteil (70) verrastbar ist.

2. Transportwagen nach Anspruch 1, bei dem der Gleitkörper (42.1, 42.2) an seinem, dem Transportwagen (10) zugewandten Ende um eine horizontal verlaufende Achse (46.1, 46.2) drehbar gelagert ist und an seinem anderen, der Schiene (62) zugewandten freien Ende mindestens ein Führungsmittel (52.1, 52.2) zur reibungsarmen Bewegung entlang der Schiene (62) aufweist.

3. Transportwagen nach Anspruch 2, bei dem das Führungsmittel (52.1, 52.2) aus einer drehbar gelagerten Rolle oder Kugel besteht.

4. Transportwagen nach Anspruch 1, bei dem die Einrichtung (38) zwei, beabstandet zueinander angeordnete Gleitkörper (42.1, 42.2) aufweist.

5. Transportwagen nach Anspruch 1, bei dem das Rastmittel (60) einen in Gleitrichtung des Gleitkörpers (42.1, 42.2) ausgerichteten, federnd geführten Rasthaken umfaßt.

6. Transportwagen nach Anspruch 1, bei dem der oder die Gleitkörper (42.1, 42.2) und das oder die Rastmittel (58, 60) auf einem gemeinsamen Träger (56) angeordnet sind.

7. Transportwagen nach Anspruch 1, bei dem das Rastmittel (58, 60) als Teil eines elektrischen Steckverbinders gestaltet ist, dessen korrespondierender Teil (72) von einem maschinenseitig angeordneten Bauteil gebildet wird.

8. Transportwagen nach Anspruch 7, bei dem das Rastmittel Kontaktstifte aufweist, die in korrespondierenden Kontaktöffnungen des Rastteils kontaktierbar sind.

9. Transportwagen nach Anspruch 7, bei dem das Rastmittel Kontaktöffnungen aufweist, in die korrespondierende Kontaktstifte (74.1, 74.2) des Bauteils (72) einsteckbar sind.

10. Transportwagen nach Anspruch 1 mit mindestens vier, bodenseitigen Rollen (30.1, 30.2, 30.3) und mindestens vier bodenseitigen Kugeln (36), wobei die Rollen (30.1, 30.2, 30.3) und/oder die Kugeln (36) derart verstellbar sind, daß der Transportwagen (10) entweder auf den Rollen (30.1, 30.2, 30.3) oder auf den Kugeln (36) bewegbar ist.

11. Transportwagen nach Anspruch 1 mit mehreren Regalflächen zur Aufnahme entsprechender zu transportierender Teile (18) und einem Manipulator (20) zum Umsetzen der Teile (18) vom Transportwagen (10) zur Maschine (40) oder umgekehrt.

12. Transportwagen nach Anspruch 11, bei dem der Manipulator (20) höhenverstellbar auf dem Transportwagen (10) geführt ist und mindestens einen, in mindestens zwei unterschiedlichen Richtungen verfahrbaren Arm (26) aufweist.

13. Transportwagen nach Anspruch 12, bei dem der Arm (26) an seinem freien Ende (26e) mit einer Greifeinrichtung ausgebildet ist.

14. Transportwagen nach Anspruch 11, bei dem der Manipulator (20) zwischen mindestens zwei Regaleinheiten (14, 16) mit jeweils mindestens einer Regalfläche angeordnet ist.
